Europäisches Patentamt

European Patent Office

Office européen des brevets

(19)

(11) Veröffentlichungsnummer : **0 111 957**
**B1**

(12) ## EUROPÄISCHE PATENTSCHRIFT

(45) Veröffentlichungstag der Patentschrift :
30.07.86

(21) Anmeldenummer : 83201703.2

(22) Anmeldetag : 01.12.83

(51) Int. Cl.⁴ : **C 23 C 14/02, G 11 B 7/20,
G 02 B 1/10, G 02 B 5/08//
C03C17/36**

(54) Verfahren zum Anbringen einer Metallschicht auf einem Substrat.

(30) Priorität : **10.12.82 NL 8204783**

(43) Veröffentlichungstag der Anmeldung :
**27.06.84 Patentblatt 84/26**

(45) Bekanntmachung des Hinweises auf die Patenterteilung : **30.07.86 Patentblatt 86/31**

(84) Benannte Vertragsstaaten :
**CH DE FR GB LI NL SE**

(56) Entgegenhaltungen :
**DE-A- 2 218 515
DE-A- 2 735 802
DE-B- 1 088 021
GB-A-    466 482
GB-A-    835 287
GB-A- 1 474 842
US-A- 3 978 252**

(73) Patentinhaber : **N.V. Philips' Gloeilampenfabrieken
Groenewoudseweg 1
NL-5621 BA Eindhoven (NL)**

(72) Erfinder : **Ponjeé, Johannes J.
c/o INT OCTROOIBUREAU B.V. Prof. Holstlaan 6
NL-5656 AA Eindhoven (NL)**
Erfinder : **Nelissen, Johan W.A.
c/o INT OCTROOIBUREAU B.V. Prof. Holstlaan 6
NL-5656 AA Eindhoven (NL)**
Erfinder : **Verwijlen, Christiaan J. A.
c/o INT OCTROOIBUREAU B.V. Prof. Holstlaan 6
NL-5656 AA Eindhoven (NL)**

(74) Vertreter : **Jelmorini, Pius Antonius et al
INTERNATIONAAL OCTROOIBUREAU B.V. Prof. Holstlaan 6
NL-5656 AA Eindhoven (NL)**

EP 0 111 957 B1

## Beschreibung

Die Erfindung bezieht sich auf ein Verfahren zum Anbringen einer auf einem Substrat haftenden Metallschicht mittels eines Haftvermittlers aus einem Alkoxysilylalkylthiol, einem Alkoxysilylalkylamin oder einem Chorsilylalkylthiol.

Aus der DE-OS-30 16 560 ist ein derartiges Verfahren bekannt, wobei als Haftvermittler ein Alkoxysilylalalkylthiol, ein Alkoxysilylalalkylamin oder ein Chlorsilylalkylthiol verwendet wird. Das Molekül dieses Haftvermittlers heftet sich auf einer Seite, der Silikatseite an das Substrat. Dadurch gelangt die Schwefel- bzw. Amingruppe auf die Aussenseite, so dass eine gute Haftung mit Metallen erhalten wird.

Beim Anbringen des Haftvermittlers als solchem oder in Form einer Lösung durch Tauchen oder Spritzen wird die Verbindung polymerisiert. Gegebenenfalls wird vor dem Anbringen des Haftvermittlers eine Basisschicht auf Basis eines Polysiloxans angebracht.

Es besteht jedoch das Bedürfnis, eine dünne Metallschicht fest anzubringen auf einem Substrat, dessen Oberfläche ultraglatt poliert oder mikroprofiliert ist, wobei das Profil nach dem Anbringen der Metallschicht erhalten bleiben soll. Ein Beispiel der genannten Mikroprofilierung ist ein digitales Informationsmuster in Form von Vertiefungen mit unterschiedlich gestalteten Oberflächenbereichen in der Grössenordnung von 1 μm² bei einer Genauigkeit von 0,1 μm².

Mit Hilfe eines auf übliche Weise aufgetragenen Siloxanharzes kann dies nicht erreicht werden.

Der Erfindung liegt die Aufgabe zugrunde, eine Metallschicht auf einem Substrat derart anzubringen, dass eine ultraglatte oder mikroprofilierte Substratoberfläche in der angebrachten Metallschicht reproduzierbar erhalten bleibt.

Diese Aufgabe wird erfindungsgemäss dadurch gelöst, dass auf der Substratoberfläche, die entweder bereits hydrophil ist oder vorher hydrophil gemacht wird, der Haftvermittler als Monomer in einer höchstens 15 Moleküle dicken Schicht angebracht wird durch Kontakt mit einer Atmosphäre, in der der Haftvermittler in Dampfform vorhanden ist, und dass darauf dann die Metallschicht mit einer Dicke von 50-300 nm angebracht wird.

Vorzugsweise wird die Schicht des Haftvermittlers in einer Monomolekularschicht angebracht.

Das Substrat, mit dem das Verfahren erfolgreich durchgeführt werden kann, muss hydrophil sein oder hydrophil gemacht sein, damit eine gute Haftung mit den alkoxylierten Silangruppen hergestellt wird.

Ein Substrat aus Glas, aus Quarz oder aus Silicium, das immer mit einer natürlichen Oxidhaut bedeckt ist, hat auf der Oberfläche eine bereits ausreichende Anzahl freier OH-Gruppen, um die alkoxylierten Silangruppen zu binden unter Abspaltung von Methanol. Die meisten Kunststoffe sind an sich nicht hydrophil, können aber durch eine oxidierende Vorbehandlung hydrophil gemacht werden. Eine sehr geeignete oxidierende Behandlung, der beispielsweise Polymethylmethakrylat ausgesetzt werden kann, und die die Oberfläche derart geringfügig angreift, dass die Profilierung beibehalten wird, ist eine Glimmentladung in einer sauerstoffreichen Atmosphäre. Ein Polycarbonat kann durch eine Behandlung mit einer verdünnten Bichromatschwefelsäurelösung hydrophil gemacht werden.

Eine interessante Möglichkeit ist die Herstellung eines Spiegels mit einer ultraglatten Oberfläche. Dabei wird von einem Aluminiumsubstrat ausgegangen, dessen Oberfläche durch eine herkömmliche Bearbeitung, beispielsweise mit einer normalen Drehbank geglättet worden ist und folglich mikroskopisch gesehen eine ziemlich hohe Rauheit aufweist. Mittels einer Quarlehre, deren Oberfläche ein ultraglattes Profil hat, wird die Oberfläche des Substrates mit einem Kunststoff, beispielsweise einem Akrylat, in den Vertiefungen gefüllt, der Kunststoff wird mittels einer UV-Bestrahlung polymerisiert und auf diese Weise auf denselben hohen Glattheitsgrad gebracht wie die Quarlehre. Daraufhin wird das Substrat einer oxidierenden Vorbehandlung ausgesetzt, beispielsweise der obengenannten Glimmentladung in einer Sauerstoffatmosphäre. Dadurch werden die Kunststoffteile der Oberfläche oxidiert und es findet zugleich eine Reinigung derselben statt. Nach Anbringen des Haftvermittlers auf die bereits beschriebene Weise wird eine dünne Silber- oder Goldschicht aufgebracht, zum Beispiel durch Aufdampfen.

Ein derartiger Spiegel wird beispielsweise bei einem IR-Nachsichtgerät benutzt.

Die Dicke der durch Aufdampfen anzubringenden Metallschicht ist von der konkreten Ausführungsform abhängig. Beim Metallisieren des obengenannten digitalen Informationsmusters wird eine Schicht von 50-100 nm aufgedampft. Beim Metallisieren einer ultraglatten Oberfläche kann die Schicht dicker — bis 300 nm — sein.

Beispiel 1

Auf einer Quarzmatrize wird eine Schicht mit einer Dicke von 20 μm des monomeren 4.4-Isopropylidenphenol-di- (äthylenglykolmethakrylat)-äther, dem in einer Menge von 4 Gew. % der Fotoinitiator Benzyldimethylketal hinzugefügt worden ist, durch Aufgiessen angebracht.

Daraufhin wird die bedeckte Matrize durch Belichtung über die Quarzmatrize fotopolymerisiert. Die belichtete Schicht wird fest auf einem Aluminiumsubstrat angebracht und das Ganze wird dann von der Matrize entfernt. Dadurch ist das Substrat mit einer Kunststoffbedeckung versehen, deren Profilierung in der Oberfläche der der Matrize genau entspricht.

Die hydrophobe Kunststoffoberfläche wird daraufhin durch eine Glimmentladung in einem Sau-

erstoffplasma während 30 Minuten mit einer Wechselspannung von 3-4 kV hydrophil gemacht.

Der Gegenstand wird daraufhin in einen Exsikkator gestellt, in welchem eine Schale mit 3-Mercaptopropyltrimethoxysilan (= trimethoxysilylpropylthiol-3) steht und ein Druck von 133 mbar eingestellt ist. Die partielle Dampfspannung des 3-Mercaptopropyltrimethoxysilan reicht aus, um mit der hydrophilen Oberfläche des Gegenstandes zu reagieren. Nach 20 Stunden Verweilzeit im Exsikkator, die eine monomolekulare Schicht dieser Verbindung erzeugt, wird der Gegenstand demselben entnommen und es wird eine Goldschicht mit einer Dicke von 0,05-0,3 μm auf bekannte Weise durch Aufdampfen angebracht.

Das Haftvermögen der Goldschicht auf der Kunststoffoberfläche wird entsprechend dem sogenannten « Diamant-Kratzverfahren » (DIN 53 151) wie folgt geprüft.

Es werden 12 Ritzlinien durch die Metallschicht hindurch eingekratzt. Das Muster von Ritzlinien besteht aus 6 parallelen Ritzlinien in einem Abstand von 1 mm voneinander, die durch ebenfalls 6 parallele Ritzlinien in einem Abstand von 1 mm voneinander senkrecht gekreuzt werden, so dass das eingekratzte Muster 25 quadratische Flächen von 1 mm² umfasst. Ein Klebestreifen wird auf das Muster gedrückt und danach von der Oberfläche abgerissen. Das Haftvermögen wird durch die folgenden Bewertungsnoten angegeben, wobei O = optimalem Haftvermögen entspricht : O Quader werden von der Oberfläche abgezogen

1 = gutes Haftvermögen : 1-5 Quader lösen sich

2 = relativ gutes Haftvermögen : 6-10 Quader lösen sich

3 = unzureichendes Haftvermögen : 11-15 Quader lösen sich

4 = schlechtes Haftvermögen : 16-20 Quader lösen sich

5 = kein Haftvermögen : 21-25 Quader lösen sich.

Das Haftvermögen der Goldschicht auf der Kunststoffoberfläche nach dem oben angeführten Beispiel konnte mit der Bewertungsnote O (optimales Haftvermögen) bewertet werden.

## Beispiel 2

Das Verfahren aus Beispiel 1 gilt auch für dieses Beispiel mit Ausnahme davon, dass statt Gold Silber auf dem mit der Polymerschicht und dem darauf angebrachten Haftvermittler versehenen Substrat angebracht wird.

Das Haftvermögen entsprechend dem beschriebenen DIN-Test war ebenfalls mit der Bewertungsnote O zu bewerten.

## Beispiel 3

Eine Siliciumscheibe, von der eine Oberflächenschicht in SiO₂ umgewandelt worden ist, wird durch eine Glimmentladung auf die Weise wie im Beispiel 1 beschrieben, hydrophil gemacht und auf dieselbe Weise wie in diesem Beispiel beschrieben mit einer monomolekularen Schicht aus 3-Mercaptopropyltrimethoxysilan behandelt. Daraufhin wird eine Gold- oder Silberschicht mit einer Dicke von 0,05-0,3 μm aufgedampft. Das Haftvermögen einer solchen Schicht entsprach einer Bewertungsnote O nach DIN 53 151.

Als Haftvermittler kann man mit demselben Ergebnis 3-Aminopropyltrimethoxysilan (trimethoxysilylpropylamin-3) oder 3-Mercaptopropyltrichlorsilan (= Trichlorsilylpropyl-3-Thiol) verwenden.

Das erreichte optimale Haftvermögen des Edelmetalls an der Siliciumscheibe bleibt unverändert, auch wenn die metallisierte Scheibe 14 Tage lang bei einer Temperatur von 170 °C erwärmt worden ist. Der grosse Unterschied in dem Ausdehnungskoeffizienten zwischen dem Si und dem Edelmetall wird also ohne weiteres durch die Haftschicht nach der Erfindung ausgeglichen.

## Patentansprüche

1. Verfahren zum Anbringen einer auf einem Substrat haftenden Metallschicht mittels eines Haftvermittlers aus einem Alkoxysilylalkylthiol, einem Alkoxysilylalkylamin oder einem Chlorsilylalkylthiol, dadurch gekennzeichnet, dass der Haftvermittler auf der Substratoberfläche, die entweder bereits hydrophil ist oder vorher hydrophil gemacht wird, als Monomer in einer höchstens 15 Moleküle dicken Schicht angebracht wird durch Kontakt mit einer Atmosphäre, in der der Haftvermittler in Dampfform vorhanden ist und dass darauf dann die Metallschicht mit einer Dicke von 50 bis 300 nm durch Aufdampfen angebracht wird.

2. Verfahren nach Anspruch 1, dadurch gekennzeichnet, dass der Haftvermittler in einer Monomolekularschicht angebracht wird.

3. Verfahren nach Anspruch 1 oder 2, dadurch gekennzeichnet, dass eine Substratoberfläche hydrophil gemacht wird mittels einer Glimmentladung in einer oxidierenden Atmosphäre.

## Claims

1. A method of providing a metal layer bonded to a substrate by means of a bonding agent selected from an alkoxysilylalkylthiol, an alkoxysilylalkylamine or a chlorosilylalkylthiol, characterized in that the bonding agent is provided as a monomer in a layer which is at most 15 molecules thick on said substrate surface which is already hydrophilic or is first made hydrophilic, by contact with an atmosphere in which the bonding agent is present in vapour form and that the metal layer is then provided thereon by vapour deposition in a thickness from 50 to 300 nm.

2. A method as claimed in Claim 1, characterized in that the bonding agent is provided in a monomolecular layer.

3. A method as claimed in Claim 1 or 2, characterized in that a substrate surface is made hydrophilic by means of a glow discharge in an oxidizing atmosphere.

## Revendications

1. Procédé pour déposer de façon adhérente une couche métallique sur un substrat à l'aide d'un intermédiaire d'adhérence en un alkoxysilylalkylthiol, une alkoxysilylalkylamine ou un chlorosilylalkylthiol, caractérisé en ce que sur la surface de substrat, qui est déjà hydrophile ou qui est rendue hydrophile auparavant, l'intermédiaire d'adhérence est appliqué comme monomère dans une couche d'une épaisseur d'au maximum 15 molécules par contact avec une atmosphère contenant l'intermédiaire d'adhérence sous forme de vapeur, et que sur cette dernière est appliquée ensuite la couche métallique d'une épaisseur comprise entre 50 et 300 nm.

2. Procédé selon la revendication 1, caractérisé en ce que l'intermédiaire d'adhérence est appliqué dans une couche monomoléculaire.

3. Procédé selon la revendication 1 ou 2, caractérisé en ce qu'une surface de substrat est rendue hydrophile à l'aide d'une décharge à lueur dans une atmosphère oxydante.